# EUROPEAN PATENT APPLICATION

(11) **EP 2 883 836 A1**
(43) Date of publication of application: **17.06.2015**
(21) Application number: 13828650.5
(22) Date of filing: 05.08.2013
(51) Int. Cl.: C01B 33/03

(54) **METHOD FOR PRODUCING POLYCRYSTALLINE SILICON**

(30) Priority: 07.08.2012 JP 2012174780
(71) Applicant: Tokuyama Corporation, Shunan-shi, Yamaguchi 745-0053 (JP)
(72) Inventor: MAJIMA Takuya, Shunan-shi Yamaguchi 745-0053 (JP); WAKAMATSU Satoru, Shunan-shi Yamaguchi 745-0053 (JP); SAKIDA Manabu, Shunan-shi Yamaguchi 745-0053 (JP)
(74) Representative: Beckmann, Claus
(86) International application number: PCT/JP2013/071744
(87) International publication number: WO 2014/025052

(57) **Abstract**

A process for producing polycrystalline silicon, comprising: a silicon deposition step for producing silicon through a reaction between a chlorosilane compound and hydrogen; a conversion reaction step for removing hydrogen chloride contained in an exhaust gas discharged from the silicon deposition step by bringing the exhaust gas into contact with activated carbon; a separation step for separating hydrogen contained in the gas after the conversion reaction obtained from the conversion reaction step; and a recycling step for supplying hydrogen obtained from the separation step to the silicon deposition step, wherein at least one of the following conditions (1) and (2) is satisfied: (1) the gas after the conversion reaction obtained from the conversion reaction step is brought into contact with an adsorbent containing a Lewis acid compound before the separation step; and (2) hydrogen obtained from the separation step is brought into contact with an adsorbent containing a Lewis acid compound before it is supplied to the silicon deposition step.

## Description

### TECHNICAL FIELD

The present invention relates to a process for producing polycrystalline silicon. More specifically, it relates to a process for producing polycrystalline silicon, comprising the steps of removing hydrogen chloride from an exhaust gas discharged from a silicone deposition step and recycling recovered hydrogen to the silicon deposition step, wherein an impurity containing a phosphorus atom derived from activated carbon which is a hydrogen chloride removing catalyst can be easily and effectively removed.

### BACKGROUND ART

As a process for producing polycrystalline silicon for use as a raw material for wafers for semi-conductor and photovoltaic power generation, there have been known a vapor to liquid deposition method and a Siemens method. All of these methods are technologies for depositing silicon on the surface of a high-temperature base material installed in a reactor by bringing a chlorosilane compound (especially trichlorosilane) and hydrogen into contact with the surface of the base material. According to these technologies, polycrystalline silicon having very high purity is obtained. On the other hand, an exhaust gas discharged from the reactor contains dichlorosilane, hydrogen and hydrogen chloride, and the disposal of hydrogen chloride in particular becomes a problem. To discard hydrogen chloride, hydrogen chloride must be separated from the exhaust gas by an adsorption method and neutralized with an alkali. Costs required for equipment and its operation for the above separation and neutralization are huge. Therefore, for the industrial production of high-purity polycrystalline silicon by the above technologies, the disposal cost of hydrogen chloride contained in the exhaust gas has been a big problem.

To solve this problem, the applicant of the present application proposed a technology for removing hydrogen chloride contained in the exhaust gas by subjecting it to a conversion reaction with dichlorosilane coexistent in the same exhaust gas in the presence of an activated carbon catalyst (Japanese Patent No. 3853894). According to this technology, hydrogen chloride contained in the exhaust gas can be removed efficiently, trichlorosilane regenerated by a conversion reaction between hydrogen chloride and dichlorosilane can be recycled as a raw material for silicon, and the service life of the activated carbon catalyst is long. Therefore, in this industry, this technology is considered as a very excellent technology and widely used industrially.

As described above, the exhaust gas discharged from the reactor contains hydrogen in addition to dichlorosilane and hydrogen chloride. The content of hydrogen in the exhaust gas is high and therefore, this hydrogen is recycled industrially.

In the industrial production of polycrystalline silicon, the removal of hydrogen chloride contained in the above exhaust gas and the recycling of hydrogen contained in the exhaust gas are both carried out. Stated more specifically, hydrogen recovered from the treated gas obtained by subj ecting the exhaust gas to the above conversion reaction is supplied into the reactor as part of the raw material gas for the production of polycrystalline silicon. At this point, an impurity containing a phosphorus atom (phosphorus-containing impurity) derived from activated carbon which is a conversion reaction catalyst is mixed into recovered hydrogen, thereby causing a problem that the phosphorus concentration of the produced silicon increases. When the phosphorus concentration of silicon is high, electric properties are impaired disadvantageously. When polycrystalline silicon is used, for example, in a solar cell, the permissible phosphorus concentration is about less than 200 ppb-wt.

As a matter of course, the above problem, that is, an increase in the phosphorus concentration of silicon can be improved by using activated carbon having a low content of phosphorus as a conversion reaction catalyst. However, activated carbon which is generally used as an industrial catalyst is derived from a palm shell or coal and generally contains about 200 ppm-wt of a phosphorus atom. There is a technology for reducing the phosphorus concentration of activated carbon by washing the activated carbon with an acid. This technology has a problem with the costs of equipment and its operation and can reduce the phosphorus concentration of activated carbon to about 50 ppm-wt at most even by acid washing. Therefore, the problem with the phosphorus concentration of silicon must be improved by a method other than the method of reducing the phosphorus concentration of activated carbon.

In the above description, "ppb-wt" is a unit indicating 1/1,000,000,000 based on weight, and "ppm-wt" is a unit indicating 1/1,000,000 based on weight (the same shall apply hereinunder in this text).

### DISCLOSURE OF THE INVENTION

It is therefore an object of the present invention to provide a process for producing polycrystalline silicon, comprising the steps of:
removing hydrogen chloride contained in an exhaust gas; and
recycling hydrogen recovered from the exhaust gas to a silicon deposition step, wherein
a phosphorus impurity derived from an activated carbon catalyst can be easily and effectively removed.

The inventors of the present invention conducted intensive studies to attain the above object. The inventors first found that a phosphorus impurity derived from activated carbon has a chemical tendency to take the form of PCl₃ or PH₃ in the coexistence of a chlorosilane compound, hydrogen chloride and hydrogen. Thereafter, they paid attention to the fact that these compounds work as Lewis bases since they have a lone pair of electrons on the phosphorus atom. Then, they found that when a gas used in a conversion reaction or hydrogen separated from the gas is brought into contact with a Lewis acid compound, the phosphorus impurity can be removed efficiently. The present invention was accomplished based on this finding.

That is, the present invention is a process for producing polycrystalline silicon, comprising:
a silicon deposition step for producing silicon through a reaction between a chlorosilane compound and hydrogen;
a conversion reaction step for removing hydrogen chloride contained in an exhaust gas discharged from the silicon deposition step by bringing the exhaust gas into contact with activated carbon;
a separation step for separating hydrogen contained in the gas after the conversion reaction obtained from the conversion reaction step; and
a recycling step for supplying hydrogen obtained from the separation step to the silicon deposition step, wherein
at least one of the following conditions (1) and (2) is satisfied:
   (1) the gas after the conversion reaction obtained from the conversion reaction step is brought into contact with an adsorbent containing a Lewis acid compound before the separation step; and
   (2) hydrogen obtained from the separation step is brought into contact with an adsorbent containing a Lewis acid compound before it is supplied to the silicon deposition step.

### BEST MODE FOR CARRYING OUT THE INVENTION

The process for producing polycrystalline silicon to which the present invention is applied comprises:
a silicon deposition step for producing silicon through a reaction between a chlorosilane compound and hydrogen;
a conversion reaction step for removing hydrogen chloride contained in an exhaust gas discharged from the silicon deposition step by bringing the exhaust gas into contact with activated carbon;
a separation step for separating hydrogen contained in the gas after the conversion reaction obtained from the conversion reaction step; and
a recycling step for supplying hydrogen obtained from the separation step to the silicon deposition step.

### <silicon deposition step>

The silicon deposition step is the step of producing silicon through a reaction between a chlorosilane compound and hydrogen to deposit it, more specifically, a Siemens method (bell jar method) or a vapor to liquid deposition method (VLD method).

The above Siemens method is a batch method in which a silicon core wire installed in a reactor (bell jar) is heated at a temperature higher than the silicon deposition temperature (for example, 600 to 1,200°C) and brought into contact with a raw material gas containing a chlorosilane compound and hydrogen to deposit silicon on the surface of the silicon core wire.

The above vapor to liquid deposition method is a sequential method in which a base material installed in a reactor is heated at a temperature higher than the silicon deposition temperature (for example, 600°C or higher), a raw material gas containing a chlorosilane compound and hydrogen is flown over and brought into contact with the base material to deposit silicon on the surface of the base material, and the base material is kept at a temperature higher than the melting point of silicon (for example, 1,450 to 1,700°C) to melt drop the deposited silicon so as to recover it; or a continuous method in which a base material installed in a reactor is heated at a temperature higher than the melting point of silicon (for example, 1,450 to 1,700°C), and a raw material gas containing a chlorosilane compound and hydrogen is flown over and brought into contact with the base material to deposit silicon on the surface of the base material and melt drop it.

Examples of the chlorosilane compound contained in the above raw material gas include trichlorosilane and dichlorosilane, out of which trichlorosilane is particularly preferred. The concentration of hydrogen contained in the above raw material gas may be excessive amount as compared with the chlorosilane compound, for example, 5 moles or more based on 1 mole of the chlorosilane compound.

### <conversion reaction step>

In the conversion reaction step, the exhaust gas discharged from the above silicon deposition step is brought into contact with activated carbon to remove hydrogen chloride contained in the exhaust gas.

The exhaust gas contains at least a chlorosilane compound, hydrogen and hydrogen chloride. Thischlorosilane compound contains a thermally decomposed product of the chlorosilane compound contained in the raw material gas and an unreacted chlorosilane compound, for example, at least one selected from tetrachlorosilane, trichlorosilane, dichlorosilane, monochlorosilane, hexachlorodisilane and pentachlorodisilane. Hydrogen contains hydrogen produced by the thermal decomposition of the chlorosilane compound contained in the raw material gas and unreacted hydrogen. Hydrogen chloride is by-produced from the deposition reaction of silicon. The concentration of hydrogen chloride contained in the exhaust gas is, for example, 0.1 to 6 mol%, specifically 0.2 to 3 mol%.

In the conversion reaction step of the present invention, hydrogen chloride contained in the exhaust gas is removed through a conversion reaction between it and the chlorosilane compound contained in the exhaust gas. Examples of the conversion reaction are given below.
Main reaction when the chlorosilane compound is dichlorosilane;

HCl + SiH₂Cl₂ → SiHCl₃ + H₂

Main reaction when the chlorosilane compound is hexachlorodisilane;

HCl + SiCl₆ → SiHCl₃ + SiCl₄

Main reaction when the chlorosilane compound is pentachlorodisilane;

HCl + SiHCl₅ → 2SiHCl₃

The conversion reaction may be carried out by adding a chlorosilane compound to the exhaust gas. This additional chlorosilane compound is used to enhance the removal efficiency of hydrogen chloride contained in the exhaust gas. Therefore, it is not particularly limited if it is a chlorosilane compound which reacts with hydrogen chloride. As the additional chlorosilane compound may be used trichlorosilane, dichlorosilane and monochlorosilane. As for the amount of the additional chlorosilane compound, the total amount of the chlorosilane compound after addition is preferably 1 mole or more, more preferably 1.2 moles or more based on 1 mole of hydrogen chloride contained in the exhaust gas. The total amount of the chlorosilane compound after addition is preferably 1.5 moles or less based on 1 mole of hydrogen chloride contained in the exhaust gas so as to maintain the volume of a circulating gas at a suitable range.

The above conversion reaction is catalyzed by activated carbon. As activated carbon which is a conversion reaction catalyst is preferably used activated carbon having pore distribution characteristics. Stated more specifically, it is preferred to use activated carbon having a pore radius (R) having a maximum peak in a pore distribution curve obtained by a water vapor adsorption method of 1.2 x 10⁻⁹ to 4.0 x 10⁻⁹ m so as to carry out the conversion reaction efficiently. The specific surface area of the activated carbon is preferably 500 m²/g or more from the viewpoint of carrying out an addition reaction efficiently by enhancing the contact efficiency of the gas. The specific surface area of the activated carbon is more preferably 600 to 1,000 m²/g. The above specific surface area is a value measured by a BET method using nitrogen as an adsorbate (the same shall apply hereinafter in this text).

The shape of the activated carbon is not particularly limited but preferably a particulate, honeycomb-like or fibrous shape. The size of the activated carbon is preferably 1 to 5 mm as a sphere-equivalent diameter from the viewpoint of handling ease.

It is premised that the activated carbon used in the conversion reaction step of the present invention contains phosphorus. Therefore, the activated carbon as a conversion reaction catalyst may be derived from a palm shell or coal. Activated carbon which is now used industrially contains about 200 ppm-wt of a phosphorus atom and accordingly, the content of phosphorus in the obtained polycrystalline silicon generally becomes so high that the electric properties of silicon are impaired. Therefore, the present invention can be applied to almost all the industrial silicon deposition methods which are carried out by using activated carbon to remove hydrogen chloride.

In general, activated carbon readily adsorbs water contained in air. When activated carbon which has adsorbed water is used in the conversion reaction step, the water reacts with the chlorosilane compound contained in the exhaust gas to produce silicon oxide on the activated carbon. When silicon oxide is produced on the activated carbon, there occurs inconvenience such as the clogging of a pipe or contamination disadvantageously. Therefore, the activated carbon is preferably used in the conversion reaction after the adsorbed water is removed. As for the method of removing water, at least one of depressurization and heating may be employed. This depressurization treatment may be carried out by maintaining the absolute pressure at 1 x 10⁴ Pa or less, preferably 1 x 10³ Pa or less, for a certain period of time. The heating treatment may be carried out by maintaining the temperature at 80 to 130°C for a certain period of time. This heating treatment is preferably carried out in a stream of an inert gas or under reduced pressure. Examples of the inert gas in use include nitrogen, helium and argon. The degree of depressurization when the heating treatment is carried out under reduced pressure is the same as the degree of depressurization in the above depressurization treatment.

All of the depressurization treatment and the heating treatment are preferably carried out until water contained in the activated carbon is completely removed. Whether water has been completely removed or not can be confirmed by the measurement of the dew point of atmosphere. The removal of water is carried out until the dew point of atmosphere becomes preferably -30°C or lower, more preferably -40°C or lower.

The reaction temperature, reaction time and reaction pressure of the conversion reaction may be suitably set according to the concentrations of hydrogen chloride and the chlorosilane compound contained in the exhaust gas. Stated more specifically, they are as follows.

Reaction temperature: preferably 60 to 250°C, more preferably 100 to 200°C

Reaction time (residence time): preferably 0.5 to 30 seconds, more preferably 5 to 15 seconds

Preferably, the diameter of the contact bed, the amount of the activated carbon and the flow rate of the gas are relatively adjusted to ensure that the contact time (reaction time) between the activated carbon and hydrogen chloride falls within the above range when hydrogen chloride is removed.

Hydrogen chloride contained in the exhaust gas is removed by the above conversion reaction efficiently. The concentration of hydrogen chloride contained in the exhaust gas after the conversion reaction can be preferably set to 0.1 mol% or less.

This conversion reaction is an exothermic reaction. Therefore, the exhaust gas used in the conversion reaction is brought into contact with activated carbon at a high temperature. As a result, a phosphorus impurity contained in the activated carbon is mixed into the gas after the conversion reaction. In the process of the present invention, examples of the phosphorus impurity contained in the gas after the conversion reaction include PCl₃ and PH₃. At least one of them is contained. The concentration of the phosphorus impurity contained in the gas after the conversion reaction is about 200 to 2,000 ppb-wt in terms of a phosphorus atom.

### <separation step>

In the separation step, hydrogen is separated from the gas after the conversion reaction obtained from the above conversion reaction step. The gas after the conversion reaction contains at least hydrogen and a chlorosilane compound. This chlorosilane compound contains a thermally decomposed product of the chlorosilane compound contained in the raw material gas, an unreacted chlorosilane compound and a chlorosilane compound (and a phosphorus impurity) produced in the conversion reaction. Examples thereof include tetrahydrosilane, trichlorosilane, dichlorosilane, monochlorosilane, hexachlorodisilane and pentachlorodisilane.

Therefore, this separation step is substantially a step for separating hydrogen and the chlorosilane compound from the gas after the conversion reaction.

To separate hydrogen and the chlorosilane compound from the gas after the conversion reaction, known means may be used without restriction. The means is, for example, a method in which the gas after the conversion reaction is cooled to concentrate and liquefy the chlorosilane compound so as to separate hydrogen. Cooling is carried out to ensure that the gas after the conversion reaction reaches a temperature of preferably -10°C or lower, more preferably -40 to -20°C.

### <recycling step>

In this recycling step, hydrogen obtained from the above separation step is recycled and supplied to the above silicon deposition step. To supply the separated hydrogen to the silicon deposition step, means for circulating hydrogen by means of a compressor is employed. Examples of this compressor include a turbo compressor and a volume compressor.

At this point, the chlorosilane compound obtained from the above separation step may also be supplied to the above silicon deposition step after it is purified as required. As the method of purifying the chlorosilane compound obtained from the separation step, distillation may be employed. To recycle the chlorosilane compound to the silicon deposition step, the chlorosilane compound is preferably supplied to the silicon deposition step through a different line from the circulation line of hydrogen.

### <adsorbent containing a Lewis acid compound>

The process of the present invention is characterized in that at least one of the following conditions (1) and (2) is satisfied in the polycrystalline silicon production process comprising the above steps.
(1) The gas after the conversion reaction obtained from the conversion reaction step is brought into contact with an adsorbent containing a Lewis acid compound before the separation step.
(2) Hydrogen obtained from the separation step is brought into contact with an adsorbent containing a Lewis acid compound before it is supplied to the silicon deposition step.

By satisfying at least one of the above conditions, the phosphorus impurity derived from activated carbon contained in the gas after the conversion reaction can be efficiently removed, thereby making it possible to reduce the content of the phosphorus atom in the obtained polycrystalline silicon as much as possible.

The adsorbent used in the present invention contains a Lewis acid compound.

Examples of the above Lewis acid compound include AlCl₃, Al₂(SO₄)₃, CuSO₄ and NiSO₄. At least one selected from these can be advantageously used. Out of these, CuSO₄ is preferably used because it has the great effect of removing the phosphorus impurity.

The above Lewis acid compound may be used as it is or while it is impregnated into a base material. When the Lewis acid compound is used while it is impregnated into the base material, the effective surface area of the Lewis acid compound can be increased, whereby the removal efficiency of the phosphorus impurity becomes extremely high advantageously.

The above base material may be silica gel, zeolite or alumina. As the above zeolite, both natural zeolite and synthetic zeolite (such as molecular sieves) may be used.

The specific surface area of the base material is preferably 50 m²/g or more, more preferably 80 to 1,000 m²/g, particularly preferably 100 to 500 m²/g.

The base material is preferably subjected to impregnation after it is classified into particles having a diameter of 1 to 5 mm.

To impregnate the base material with the Lewis acid compound, known means may be employed. For example, a solution is prepared by dissolving the Lewis acid compound in a suitable solvent, the base material is immersed in the solution or the solution is sprayed over the base material, and the base material is heated to remove the solvent. An example of the solvent for the above solution is water.

When the base material is impregnated with the Lewis acid compound by immersion, the concentration of the Lewis acid compound in the solution can be suitably adjusted according to the desired amount of impregnation. For example, when the amount of impregnation is 5 wt%, the concentration of the Lewis acid compound in the solution is preferably set to 10 to 20 wt%. The amount of the solution used for immersion is preferably such that the base material is completely submerged in the solution in an immersion vessel. The immersion temperature may be room temperature, and heating or cooling is not necessary. The immersion time is preferably 6 to 36 hours. After the base material after immersion is separated from the solution by a suitable method, for example, filtration, it is preferably washed with a solvent, then the solvent is removed by heating. The solvent used herein is preferably of the same kind as the solvent for the Lewis acid compound solution. The heating temperature is preferably 130°C or higher. Heating is preferably carried out in a stream of an inert gas. Examples of the inert gas used herein include nitrogen, helium and argon. This heating is preferably carried out until the solvent is completely removed. The removal of the solvent is carried out until the dew point when the impregnated base material after heating is placed in an inert gas becomes preferably -30°C or lower, more preferably -40°C or lower.

The amount of the Lewis acid compound impregnated into the base material should be suitably set according to the concentration of the phosphorus impurity to be removed and may be, for example, 1 to 20 wt%, preferably 3 to 15 wt% based on the weight of the base material. The amount of impregnation can be measured by elemental analysis or fluorescent X-ray analysis. The amount of impregnation can be controlled by changing the concentration of the Lewis acid compound solution in use, the temperature of the base material at the time of immersing or spraying. The suitable impregnation conditions can be easily known from a few preliminary experiments conducted by a person having ordinary skill in the art.

The adsorbent prepared by impregnating the base material with the Lewis acid compound as described above is preferably used after classification to a particle diameter of 1 to 5 mm.

The base material contained in the above adsorbent readily absorbs water contained in air. Therefore, when the adsorbent is to be brought into contact with the gas after the conversion reaction before the separation step, water adsorbed by the adsorbent is preferably removed in advance. This treatment is carried out to prevent inconvenience such as the reduction of adsorption activity by the coverage of the surface of the adsorbent, the clogging of a pipe or contamination due to the formation of silicon oxide through a reaction between the chlorosilane compound contained in the gas after the conversion reaction before the separation step and the adsorbed water.

Meanwhile, when the adsorbent prepared by impregnating the base material with the Lewis acid compound is to be brought into contact with hydrogen after the separation step, there is no concern about the formation of silicon oxide at the time of contact. However, the desorbed water may be brought into the reactor together with hydrogen after the treatment. Since the chlorosilane compound is existent in the reactor, the formation of silicon oxide is apprehended. Therefore, even in this case, the removal of water is preferably carried out in advance.

To remove water, at least one of depressurization and heating is carried out. The method of depressurization treatment and the degree of depressurization are the same as those described for the removal of water from activated carbon.

The base material which is preferably used in the present invention contains at least one of a silicon atom and an aluminum atom. An M-OH (M is silicon or aluminum) group may remain on the surface of the adsorbent prepared by using this base material.

When the adsorbent having an M-OH group on the surface is brought into contact with the gas after the conversion reaction before the separation step, the M-OH group and the chlorosilane compound are drastically reacted with each other to generate heat surpassing the heat resistance of the reactor, whereby the reactor may be damaged. When M is a silicon atom, a tendency toward heat generation is more marked. To avoid this situation, before the adsorbent is brought into contact with the gas after the conversion reaction before the separation step, it is preferred that the M-OH group on the surface of the adsorbent should be deactivated.

To deactivate the M-OH group on the surface of the adsorbent, the adsorbent is brought into contact with a suitable M-OH bond deactivator. This contact may be carried out in a liquid phase or gas phase. However, it is preferably carried out in a gas phase because the operation is simple and a post-treatment is not necessary.

A deactivator used to deactivate the M-OH group on the surface is not particularly limited if it can deactivate the bond. However, in consideration of possibility that the deactivator may remain on the adsorbent to be mixed into the process, species which are existent in the process are preferably used as the deactivator. This deactivator is preferably a chlorosilane compound. Examples of the above chlorosilane compound include dichlorosilane, trichlorosilane and tetrachlorosilane. Out of these, tetrachlorosilane which has the lowest reactivity with the M-OH bond is preferably used as it can promote the deactivation of the M-OH bond moderately.

When the deactivation of the surface M-OH group is carried out in a gas phase, the adsorbent is brought into contact with a mixed gas of the above chlorosilane compound and an inert gas. The concentration of the chlorosilane compound in this mixed gas is preferably 0.5 vol% or less, more preferably 0.1 to 0.3 vol%. Examples of the inert gas to be mixed with the chlorosilane compound include nitrogen, helium and argon.

The conditions for bringing the adsorbent into contact with the deactivator in a gas phase must be suitably set depending on the concentration of the surface M-OH group, the amount of the adsorbent and the type and concentration of the deactivator in use and cannot be flatly determined.

However, the following values can be presented as general conditions.

Temperature at the time of contact with deactivator: preferably 20 to 100°C, more preferably 40 to 80°C Contact time of deactivator (residence time): preferably 30 to 120 seconds

When a chlorosilane compound is used as the deactivator, the reaction between the chlorosilane compound and the surface M-OH group is an exothermic reaction. Therefore, the completion of a deactivation reaction can be known by monitoring temperature variations near the adsorbent.

### <contact with adsorbent>

The present invention is characterized in that at least one of the following conditions (1) and (2) is satisfied in the process for producing polycrystalline silicon, comprising a silicon deposition step, a conversion reaction step, a separation step and a circulation step.
(1) The gas after the conversion reaction obtained from the conversion reaction step is brought into contact with an adsorbent containing a Lewis acid compound before the separation step.
(2) Hydrogen obtained from the separation step is brought into contact with an adsorbent containing a Lewis acid compound before it is supplied to the silicon deposition step.

As described above, the gas after the conversion reaction contains a phosphorus impurity derived from activated carbon. The inventors confirmed that this phosphorus impurity is also contained in hydrogen after the separation step. The phosphorus impurity is not contained in the chlorosilane compound after the separation step or is contained in a very small amount if it is contained.

Therefore, to remove the phosphorus impurity from a reclaimed gas to be recycled to the silicon deposition step, at least one of the above conditions (1) and (2) should be satisfied. The contact conditions in (1) and (2) are not particularly limited.

As for the above contact, for example, the adsorbent and the gas are brought into contact with each other by flowing the gas after the conversion reaction in the case of the condition (1) or hydrogen obtained from the separation step in the case of the condition (2) into an adsorption reactor having the adsorbent as a fixed bed or fluidized bed.

The temperature at the time of contact is not particularly limited. However, it is preferably equal to or lower than the heat resistance temperature of the material constituting a contact reaction layer. Further, when an adsorbent prepared by impregnating the base material with the Lewis acid compound is used, the temperature is preferably equal to or lower than the heat resistance temperature of the base material. In the case of the condition (1), since the gas after the conversion reaction obtained from the conversion reaction step which is an exothermic reaction is used in the case of the condition (1), if the contact temperature is set excessively low, the required degree of cooling becomes too high, whereby a heat energy loss becomes insignificantly large. From this point of view, the contact temperature is preferably -40 to 200°C, more preferably 50 to 200°C, particularly preferably 80 to 150°C.

The contact time (residence time) is preferably 1 second or more. Since the obtained effect is not diminished by prolonging the contact time, there is no limitation to the upper limit of the contact time. However, in consideration of industrial convenience, it is preferably 30 seconds or less. It is more preferably 5 to 15 seconds.

The pressure at the time of contact is not particularly limited. The contact pressure may be, for example, 200 to 2,000 kPa.

In the present invention, it is preferred that only the above condition (1) should be satisfied and the condition (2) should not be satisfied. The reason for this is that when the gas after the conversion reaction and the adsorbent are brought into contact with each other, the chlorosilane compound contained in the gas after the conversion reaction is adsorbed to the adsorbent, thereby impairing the service life of the adsorbent.

The conditions for carrying out the process of the present invention industrially advantageously have been described above. However, it was confirmed that the effect of the present invention is hardly affected by temperature and pressure variations at the time of bringing the adsorbent into contact with the gas. This tendency is one of the very advantageous features of the present invention. That is, since the effect of the present invention is hardly affected by temperature and pressure at the time of contact, the contact position between the adsorbent and the gas can be set to any position without controlling the contact reaction conditions. The contact position may be set to any position between the conversion reaction step and the separation step in the case of the above condition (1); or to any position during the circulation step until the obtained hydrogen is supplied to the silicon deposition step after the separation step in the case of the condition (2).

### EXAMPLES

### <preparation examples of adsorbent>

### Preparation Example 1

100 g of particulate silica gel having a specific surface area of 250 m²/g and an average particle diameter of 3 mm was fed to a vessel having a capacity of 500 mL. 100 mL of a CuSO₄ aqueous solution having a concentration of 20 wt% obtained by dissolving copper sulfate pentahydrate in ion exchange water was added to this so as to immerse the silica gel at 25°C for 24 hours. The silica gel after immersion was recovered by filtration, washed in ion exchange water and heated at 130 °C for 24 hours in a nitrogen atmosphere to obtain an adsorbent (10 wt% CuSO₄ impregnated silica gel).

### Preparation Example 2

An adsorbent (10 wt% NiSO₄ impregnated silica gel) was obtained in the same manner as in Preparation Example 1 except that 100 mL of an NiSO₄ aqueous solution having a concentration of 20 wt% obtained by dissolving nickel sulfate hexahydrate in ion exchange water was used in place of the CuSO₄ aqueous solution.

### Preparation Example 3

An adsorbent (10 wt% Al₂(SO₄)₃ impregnated silica gel) was obtained in the same manner as in Preparation Example 1 except that 100 mL of an Al₂(SO₄)₃ aqueous solution having a concentration of 20 wt% obtained by dissolving aluminum sulfate hexadecahydrate in ion exchange water was used in place of the CuSO₄ aqueous solution.

### Preparation Example 4

An adsorbent (10 wt% CuSO₄ impregnated alumina) was obtained in the same manner as in Preparation Example 1 except that 100 mg of particulate activated alumina having a specific surface area of 180 m²/g and an average particle diameter of 3 mm was used in place of the particulate silica gel.

### Preparation Example 5

An adsorbent (10 wt% CuSO₄ impregnated zeolite) was obtained in the same manner as in Preparation Example 1 except that 100 g of particulate zeolite having a specific surface area of 180 m²/g and an average particle diameter of 3 mm was used in place of the particulate silica gel.

### Preparation Example 6

An adsorbent (3 wt% CuSO₄ impregnated silica gel) was obtained in the same manner as in Preparation Example 1 except that the concentration of the CuSO₄ aqueous solution was changed to 5 wt%.

### Preparation Example 7

An adsorbent (15 wt% CuSO₄ impregnated silica gel) was obtained in the same manner as in Preparation Example 1 except that the concentration of the CuSO₄ aqueous solution was changed to 30 wt%.

### <general experimental methodology>

In the following examples, hydrogen containing predetermined amounts of hydrogen chloride and dichlorosilane was used as a model exhaust gas discharged from the silicon deposition step.

A conversion reaction was carried out by flowing the above model gas over the conversion reaction catalyst. Hydrogen separated from the gas after the conversion reaction obtained from this conversion reaction step was flown over the predetermined adsorbent to be brought into contact with the adsorbent. A gas obtained by mixing hydrogen after its contact with the adsorbent with trichlorosilane was used as a raw material to carry out the silicon deposition step by the Siemens method so as to measure the phosphorus concentration of the obtained polycrystalline silicon.

The details of the experimental methodology are as follows.

### (1) Conversion reaction step

Particulate activated carbon having a specific surface area of 1,300 m²/g, a pore radius (R) which shows the maximum peak in a pore distribution curve obtained by a water vapor adsorption method of 1.2 x 10⁻⁹ m and an average particle diameter of 3 mm was used as a conversion reaction catalyst. This activated carbon was derived from a palm shell and had a phosphorus atom content of 200 ppm-wt.

10 g of the above activated carbon was filled into a cylindrical stainless steel vessel having an inner diameter of 27 mm and a length of 100 mm, and a thermocouple was inserted into the vessel. This thermocouple was used to measure the temperature of the activated carbon packed bed.

Water adsorbed to the activated carbon was first removed. The activated carbon layer was heated at 150°C and dry nitrogen was flown at a pressure of 2 kPaG and a flow rate of 0. 05 NL/min for 10 hours to remove the adsorbed water. Then, the activated carbon layer was cooled to 30°C to be used for the conversion reaction while the inside of the vessel was substituted by hydrogen.

The conversion reaction was carried out by using hydrogen containing 1.5 mol% of hydrogen chloride and 1.5 mol% of dichlorosilane as a model gas. The model gas was flown into the 30°C activated carbon layer at a pressure of 1 kPaG and a flow rate of 320 NmL/min. At this point, the temperature of the activated carbon layer rose to about 60°C. It is assumed that this was due to adsorption heat to the activated carbon and the reaction heat of the conversion reaction.

### (2) Separation step

After the gas discharged from the above conversion reaction was cooled to a temperature of -40°C, a gas phase was collected to separate hydrogen. The phosphorus atom concentration of the obtained hydrogen was 2,000 ppb-wt. (3) Contact step between hydrogen and adsorbent

10 g of the predetermined adsorbent was filled into a cylindrical stainless steel vessel having an inner diameter of 27 mm and a length of 100 mm, and a thermocouple was inserted into the vessel.

Water adsorbed to the adsorbent was first removed, followed by the deactivation treatment of the surface M-OH bond.

The adsorbent layer was heated at 150°C, and dry nitrogen was flown into the adsorbent layer at a flow rate of 0.05 L/min for 10 hours to remove the adsorbed water. Then, nitrogen containing 0.5 vol% of tetrachlorosilane was flown at a pressure of 10 kPaG and a flow rate of 50 NmL/min for 5 hours. Thereafter, the adsorbent layer was brought into contact with hydrogen.

After the temperature of the adsorbent layer after the above treatment was set to a predetermined temperature, hydrogen obtained in the above separation step was flown at a pressure of 1 kPaG and a predetermined flow rate to carry out a contact reaction between hydrogen and the adsorbent.

### (4) Silicon deposition step

Trichlorosilane was mixed with hydrogen obtained from the above contact step to prepare a mixed gas of hydrogen and trichlorosilane in a volume ratio of 10:1. This mixed gas was supplied to a silicon rod having a diameter of 8 mm and a length of 100 mm and heated at 1,200°C so as to deposit polycrystalline silicon on the surface of the silicon rod.

The phosphorus atom concentration of the obtained polycrystalline silicon was measured by elemental analysis.

### Reference Example 1 (blank test)

Polycrystalline silicon was obtained by the same operation as that of "(4) silicon deposition step" except that hydrogen containing no phosphorus impurity was used as raw material hydrogen.

The phosphorus atom concentration of the obtained polycrystalline silicon is shown in Table 1.

### Comparative Example 1 (when no adsorbent was used)

Polycrystalline silicon was obtained by the same operation as that of the above <general experimental methodology> except that an empty vessel was used without using an adsorbent and the temperature of the empty vessel was set to 80°C to carry out the above "(3) contact step between hydrogen and adsorbent".

The phosphorus atom concentration of the obtained polycrystalline silicon is shown in Table 1.

### Examples 1 to 10 and Comparative Examples 2 and 3

Polycrystalline silicon was obtained by carrying out the above steps in accordance with the above <general experimental methodology> by using the type of the adsorbent, the temperature of the adsorbent layer and the flow rate of hydrogen in the above "(3) contact step between hydrogen and adsorbent" as shown in Table 1.

The phosphorus atom concentration of the obtained polycrystalline silicon is shown in Table 1.

Silica gel and activated alumina used in Comparative Examples 2 and 3 are as follows.

Silica gel (Comparative Example 2): particulate silica gel having a specific surface area of 250 m²/g and an average particle diameter of 3 mm

Activated alumina (Comparative Example 3) : particulate activated alumina having a specific surface area of 180 m²/g and an average particle diameter of 3 mm

**Table 1**

| | Adsorbent | | Flow rate of hydrogen (NmL/min) | Phosphorus atom concentration of polycrystalline silicon (ppb-wt) |
|---|---|---|---|---|
| | Type | Temperature (°C) | | |
| Reference Example 1 | - | - | 320 | 0.5 |
| Comparative Example 1 | none | 80 | 320 | 200 |
| Example 1 | 10 wt% CuSO₄ impregnated silica gel | 80 | 320 | 0.5 |
| Example 2 | 10 wt% CuSO₄ impregnated silica gel | 30 | 320 | 0.5 |
| Example 3 | 10 wt% CuSO₄ impregnated silica gel | 150 | 320 | 0.5 |
| Example 4 | 10 wt% CuSO₄ impregnated silica gel | 80 | 3.2 | 0.5 |
| Example 5 | 10 wt% NiSO₄ impregnated silica gel | 80 | 3.2 | 5 |
| Example 6 | 10 wt% Al₂(SO₄)₃ impregnated silica gel | 80 | 3.2 | 5 |
| Example 7 | 10 wt% CuSO₄ impregnated alumina | 80 | 320 | 1 |
| Example 8 | 10 wt% CuSO₄ impregnated zeolite | 80 | 320 | 1 |
| Example 9 | 3 wt% CuSO₄ impregnated silica gel | 80 | 320 | 0.5 |
| Example 10 | 15 wt% CuSO₄ impregnated silica gel | 80 | 320 | 0.5 |
| Comparative Example 2 | Silica gel | 80 | 320 | 200 |
| Comparative Example 3 | Activated alumina | 80 | 320 | 200 |

### Effect of the Invention

According to the present invention, in the process for producing polycrystalline silicon by making use of a reaction between a chlorosilane compound and hydrogen, when the removal of hydrogen chloride contained in the exhaust gas and the recycling of hydrogen contained in the exhaust gas are both carried out, a phosphorus impurity derived from an activated carbon catalyst and contained in the circulation gas can be easily and effectively removed. Therefore, since the phosphorus atom content of polycrystalline silicon obtained by the above process of the present invention has been reduced as much as possible, the polycrystalline silicon can be advantageously used in solar cells and semiconductors.

## Claims

1. A process for producing polycrystalline silicon, comprising:
a silicon deposition step for producing silicon through a reaction between a chlorosilane compound and hydrogen;
a conversion reaction step for removing hydrogen chloride contained in an exhaust gas discharged from the silicon deposition step by bringing the exhaust gas into contact with activated carbon;
a separation step for separating hydrogen contained in the gas after the conversion reaction obtained from the conversion reaction step; and
a recycling step for supplying hydrogen obtained from the separation step to the silicon deposition step, wherein
at least one of the following conditions (1) and (2) is satisfied:
(1) the gas after the conversion reaction obtained from the conversion reaction step is brought into contact with an adsorbent containing a Lewis acid compound before the separation step; and
(2) hydrogen obtained from the separation step is brought into contact with an adsorbent containing a Lewis acid compound before it is supplied to the silicon deposition step.

2. The process for producing polycrystalline silicon according to claim 1, wherein the Lewis acid compound is at least one selected from the group consisting of CuSO₄, NiSO₄ and Al₂(SO₄)₃.

3. The process for producing polycrystalline silicon according to claim 1 or 2, wherein the adsorbent is obtained by impregnating a base material with the Lewis acid compound.

4. The process for producing polycrystalline silicon according to claim 3, wherein the base material is at least one selected from silica gel, molecular sieves, zeolite and alumina.

5. The process for producing polycrystalline silicon according to claim 4, wherein the adsorbent is used after it is treated with a chlorosilane compound.
